# EUROPÄISCHE PATENTSCHRIFT

(11) **EP 2 245 679 B1**
(45) Veröffentlichungstag und Bekanntmachung des Hinweises auf die Patenterteilung: **29.07.2015**
(21) Anmeldenummer: 09704410.1
(22) Anmeldetag: 22.01.2009
(51) Int. Cl.: H01L 41/083, H01L 41/273

(54) **PIEZOELEKTRISCHES VIELSCHICHTBAUELEMENT**
PIEZOELECTRIC MULTILAYER COMPONENT
ÉLÉMENT PIÉZOÉLECTRIQUE MULTICOUCHE

(30) Priorität: 23.01.2008 DE 102008005680
(43) Veröffentlichungstag der Anmeldung: 03.11.2010
(73) Patentinhaber: Epcos AG, 81669 München (DE)
(72) Erfinder: KÜGERL, Georg, A-8552 Eibiswald (AT); DERNOVSEK, Oliver, A-8501 Lieboch (AT); GLAZUNOV, Alexander, A-8530 Deutschlandsberg (AT)
(74) Vertreter: Epping - Hermann - Fischer
(86) Internationale Anmeldenummer: PCT/EP2009/000395
(87) Internationale Veröffentlichungsnummer: WO 2009/092585

(56) Entgegenhaltungen:
- EP-A- 1 764 844
- WO-A-2007/097460
- DE-A1- 10 307 825
- DE-A1-102005 015 112

## Beschreibung

Es wird ein piezoelektrisches Vielschichtbauelement mit einem Bereich mechanisch verringerter Stabilität angegeben.

Aus der Druckschrift DE 10 2006 031 085 A1 ist ein piezoelektrisches Vielschichtbauelement mit Sollbruchschichten bekannt.

Die Druckschrift DE 10 2005 015 112 A1 betrifft ein piezoelektrisches Bauteil, bei dem zwischen einer Elektrodenschicht und einer Piezokeramikschicht eine Entkopplungsschicht zur mechanischen Entkopplung der Elektrodenschicht und der Piezokeramikschicht angeordnet ist.

Die Druckschrift EP 1 764 844 A1 betrifft einen piezoelektrischen Aktuator, bei dem mechanisch geschwächte piezokeramische Schichten durch eine Zugabe von Dotierstoffen erzeugt werden können.

Die Druckschrift WO 2007/097460 A1 betrifft ein Vielschichtbauelement welches eine Schicht mit einem hohen Anteil an Löchern und einer Vielzahl von keramischen Klumpen aufweist.

Eine zu lösende Aufgabe besteht darin, ein piezoelektrisches Vielschichtbauelement anzugeben, welches langzeitstabil ist.

Es wird ein piezoelektrisches Vielschichtbauelement angegeben mit einem Stapel von übereinander angeordneten piezokerami schen Schichten und dazwischen liegenden Elektrodenschichten. Der Stapel weist einen ersten Bereich und einen zweiten Bereich auf, wobei der zweite Bereich ein Störmaterial enthält, durch den die mechanische Stabilität des zweiten Bereichs gegenüber dem ersten Bereich herabgesetzt ist.

Der erste Bereich und der zweite Bereich erstrecken sich innerhalb des Stapels vorzugsweise jeweils in lateraler Richtung, d. h. senkrecht zur Stapelrichtung. Sowohl der erste Bereich als auch der zweite Bereich verlaufen im Wesentlichen parallel zu den Schichten des Stapels und erstrecken sich vorzugsweise über die gesamte Querschnittsfläche des Stapels.

Jeder der beiden Bereiche kann eine oder mehrere der piezokeramischen Schichten des Stapels umfassen oder nur einen Teil einer piezokeramische Schicht umfassen. Vorzugsweise grenzen der erste Bereich und der zweite Bereich aneinander an.

Das piezoelektrische Vielschichtbauelement hat den Vorteil, dass durch bestimmte mechanische Belastungen verursachte mechanische Spannungen im Stapel durch kontrollierte Rissbildung im Bereich der verringerten mechanischen Stabilität, d. h. im zweiten Bereich abgebaut werden können. Insbesondere wird vermieden, dass zwei gegenpolige Elektrodenschichten durch einen Riss miteinander verbunden werden, da sich der Riss parallel zu den Schichten innerhalb des zweiten Bereichs verringerter mechanischer Stabilität ausbildet. Dazu grenzt an den zweiten Bereich in Stapelrichtung ein erster Bereich an, der eine höhere mechanische Stabilität als der zweite Bereich aufweist. Vorzugsweise setzt sich der erste Bereich aus zwei Teilbereichen zusammen, die den zweiten Bereich in Stapelrichtung einschließen. Somit werden Risse im zweiten Bereich geführt und breiten sich nicht in den ersten Bereich aus. Dadurch können Kurzschlüsse zwischen gegenpoligen Elektrodenschichten vermieden und die Langzeitstabilität des Bauelements gesteigert werden.

Die Schwächung des zweiten Bereiches ist durch das Störmaterial hervorgerufen. Erfindungsgemäß enthält der zweite Bereich ein Material, dessen Sinterverhalten während des Sinterns durch das Störmaterial so verändert wird, dass eine mechanische Schwächung eintritt. In einer Ausführungsform enthält der zweite Bereich piezokeramisches Material, dessen Gefüge aufgrund der Anwesenheit des Störmaterials während des Sinterprozesses, verändert ist. Vorzugsweise weist dabei das piezokeramische Material im zweiten Bereich eine höhere Porosität auf als das piezokeramische Material im ersten Bereich. Der zweite Bereich ist daher mechanisch geschwächt:

Vorzugsweise enthält der erste Bereich ebenfalls piezokeramisches Material, wobei dessen Gefüge nicht oder nur geringfügig durch Störmaterial verändert ist. Das Störmaterial kann auch in einer chemischen Verbindung mit dem Material des zweiten Bereichs vorliegen.

Weiterhin wird ein piezoelektrisches Vielschichtbauelement als Zwischenprodukt angegeben, aus dem das beschriebene piezoelektrische Vielschichtbauelement hergestellt werden kann. In das Zwischenprodukt wird ein Störmaterial eingebracht, das dazu geeignet ist, das Sinterverhalten des Materials im zweiten Bereich so zu verändern, dass eine mechanische Schwächung des zweiten Bereichs gegenüber dem ersten Bereich hervorgerufen wird.

Vorzugsweise ist das Störmaterial so gewählt, dass es bei Erwärmung des Stapels in den zweiten Bereich des Stapels diffundieren und das Sinterverhalten des zweiten Bereichs verändern kann. Das Störmaterial kann allerdings auch schon vor dem Sintern in den zweiten Bereich eingebracht sein und das Sinterverhalten des zweiten Bereichs verändern. In diesem Fall ist der zweite Bereich beispielsweise eine mit dem Störmaterial dotierte piezokeramische Schicht. Das Störmaterial kann dabei das Sinterverhalten dieser dotierten Schicht verändern und zudem in angrenzende piezokeramische Schichten diffundieren und auch deren Sinterverhalten stören. Das Störmaterial kann auch als Aktivierungsmaterial bezeichnet werden.

Gemäß einer Ausführungsform umfasst das eingebrachte Störmaterial ein Übergangsmetall. Das Störmaterial kann aus dem Übergangsmetall bestehen oder eine Mischung eines Übergangsmetalls mit einem anderen Metall umfassen. Vorzugsweise ist das andere Metall in einer Elektrodenschicht enthalten. Das hat den Vorteil, dass die Anzahl der im Stapel verwendeten Metallsorten minimiert und damit die Herstellung des Vielschichtbauelements vereinfacht wird. Das Störmaterial kann auch mit einem Keramikpulver gemischt sein. Vorzugsweise wird ein Keramikpulver verwendet, das auch für eine piezokeramische Schicht verwendet wird.

Beispielsweise enthält das Störmaterial Nickel oder besteht aus Nickel. Gemäß einer Ausführungsform ist das Störmaterial in einer chemischen Verbindung vorhanden, die ein Oxid, Hydroxid oder ein Salz umfasst.

Anstelle von Nickel können als Störmaterial auch andere Materialien verwendet werden, wie zum Beispiel Vanadium, Chrom, Mangan, Eisen, Cobalt, Zink, Gallium oder Germanium. Diese Materialien können entweder in der Form eines Metalls oder einer Legierung oder einer chemischen Verbindung wie zuvor im Fall von Nickel genannt verwendet werden.

In dem erfindungsgemäßen Zwischenprodukt ist in den Stapel wenigstens eine zusätzliche Störschicht eingebracht, die das Störmaterial enthält.
Die Störschicht kann auf einer Elektrodenschicht aufgebracht sein. Die Störschicht erstreckt sich über die gesamte Querschnittsfläche des Stapels.

In einer alternativen Ausführungsform ist die Störschicht auf eine piezokeramische Schicht aufgebracht und erstreckt sich über die gesamte Querschnittsfläche des Stapels.

Erfindungsgemäß ist die Störschicht strukturiert und deckt eine Schicht des Stapels unvollständig ab. Beispielsweise umfasst die Störschicht ein Störmaterial, das in der Form von Inseln oder in der Form einer Schicht mit Aussparungen vorliegt. Dabei kann es sich um eine Schicht handeln, die das Störmaterial enthält, wobei die Schicht eine unterbrochene Struktur aufweist.

Vorzugsweise ist die Störschicht mittels Siebdruck, Sputtern oder Sprühen erzeugt.

Die Störschicht umfasst gemäß einer Ausführungsform des Zwischenprodukts eine Schicht, in der das Störmaterial eingebracht ist. Dies ist beispielsweise eine mit dem Störmaterial dotierte piezokeramische Schicht. In diesem Fall kann die piezokeramische Schicht selbst als Sollbruchschicht dienen. Das Störmaterial kann auch in eine Elektrodenschicht eingebracht sein und während des Sinterns in angrenzende piezokeramische Schichten diffundieren.

Vorzugsweise grenzt der zweite Bereich an einen Bereich an, in dem Störmaterial enthalten ist. Bei Vorliegen einer Störschicht umfasst der zweite Bereich beispielsweise piezokeramische Schichten, die entlang der Stapelrichtung an die Störschicht angrenzen. Ist eine piezokeramische Schicht mit dem Störmaterial dotiert, so umfasst der zweite Bereich beispielsweise diese piezokeramische Schicht. Wie weit sich der zweite Bereich entlang der Stapelrichtung erstreckt, hängt vor allem von den Diffusionseigenschaften des Störmaterials und von der Menge des Störmaterials ab.

Der zweite Bereich des Vielschichtbauelements umfasst vorzugsweise ein piezokeramisches Material, insbesondere Blei-Zirkonat-Titanat (PZT). Dieses Material ist vorzugsweise in einer piezokeramischen Schicht enthalten. Es hat sich herausgestellt, dass ein solches im zweiten Bereich enthaltenes Keramikmaterial derart mit dem Störmaterial reagieren kann, dass während der Temperaturbehandlung des Vielschichtbauelements, beispielsweise während des Sinterns, die mechanische Festigkeit des zweiten Bereichs soweit abgesenkt wird, dass dieser zweite Bereich als Sollbruchbereich beziehungsweise als Sollbruchschicht dienen kann.

Je nach Auswahl des Störmaterials können dabei die Porosität und das Gefüge der umliegenden, gesinterten Keramik verändert werden. Der Grad der Veränderung eines piezokeramischen Materials hängt dabei vor allem vom Abstand zum Störmaterial, der Art des verwendeten Störmaterials und von der Menge des aufgebrachten Störmaterials ab.

Der Einfluss der Entfernung des Störmaterials von den umliegenden Schichten und der Art des Störmaterials wird bestimmt vom Diffusionsprofil des Störmaterials durch das umliegende Material. Je näher eine piezokeramische Schicht am Störmaterial liegt, desto mehr Störmaterial diffundiert während des Sinterprozesses in die piezokeramische Schicht und desto stärker wird das Sinterverhalten der piezokeramischen Schicht vom Störmaterial beeinflusst. Folglich ist auch der Riss bestimmende Einfluss bzw. der Einfluss auf die Porosität und das Gefüge nach Abschluss des Sintervorgangs abhängig von der Entfernung der piezokeramischen Schicht vom Störmaterial im Zwischenprodukt.

In piezokeramischen Schichten, die in großer Entfernung von der Störschicht liegen, kann im Extremfall sogar keine Veränderung von Porosität und Gefüge stattfinden, weil das Störmaterial der Störschicht diese Schichten während des Sintervorgangs über Diffusionsprozesse nicht erreichen kann. Vorzugsweise ist der erste Bereich des Stapels, dessen mechanische Stabilität gegenüber dem zweiten Bereich erhöht ist, weiter vom Störmaterial entfernt, als der zweite Bereich. Somit enthält der erste Bereich geringere Mengen des Störmaterials als der zweite Bereich und ist deshalb in seinem Sinterverhalten nicht oder nur geringfügig verändert.

Neben dem Abstand von einzelnen piezokeramischen Schichten von der Störschicht spielt auch die Menge des Störmaterials in der Störschicht eine Rolle. Diese Menge beeinflusst neben dem Diffusionsprofil die Konzentration vom ersten Material in der gesinterten Keramik. Wenn die Menge gering ist, wird die Veränderung von Porosität und Gefüge nach dem Abschluss des Sintervorgangs ebenfalls gering sein.

Am Ende des Sintervorgangs entsteht ein Stapel mit inhomogener Porositätsverteilung und inhomogenem Gefüge, was zu einer Verteilung von verschiedenen mechanischen Festigkeiten im Körper des Stapels führt. Beispielsweise erhalten einige piezokeramische Schichten eine geringere mechanische Festigkeit als andere. Piezokeramische Schichten mit reduzierter mechanischer Stabilität liegen vorzugsweise neben der Störschicht. Die Risse beim Polen und Betrieb des Stapels werden dabei bevorzugt in piezokeramischen Schichten mit geringerer Festigkeit entstehen. Da die angrenzenden Schichten eine höhere mechanische Festigkeit besitzen, sollen solche Risse sich nur innerhalb von Schichten mit geringerer Festigkeit fortsetzen. Der Rissverlauf findet dann im Wesentlichen parallel zu den Elektrodenschichten statt, welches zur Verlängerung der Lebensdauer des piezoelektrischen Vielschichtbauelements führt.

Um sicherzustellen, dass die Risse während der Polung und im Betrieb des Stapels beziehungsweise des piezoelektrischen Vielschichtbauelements von der Ebene der Elektrodenschichten nicht abweichen, werden vorzugsweise Porosität und Gefüge der gesamten Grundrissfläche des Vielschichtbauelements verändert, und nicht nur lokal, wie zum Beispiel nur am Rande des Vielschichtbauelements. Um dies zu erreichen, erstreckt sich die Störschicht über die gesamte Querschnittsfläche des Stapels.

Es wird außerdem ein Verfahren zur Herstellung eines piezoelektrischen Vielschichtbauelements angegeben, wobei das als Zwischenprodukt hergestellte piezoelektrische Vielschichtbauelement gesintert wird. Während des Sinterns verändert das Störmaterial das Sinterverhalten des Materials im zweiten Bereich, so dass eine mechanische Schwächung des zweiten Bereichs eintritt. Dabei kann sich das Störmaterial bereits vor der Erwärmung des Stapels im zweiten Bereich befinden oder bei Erwärmung erst in den zweiten Bereich diffundieren.

Es wird weiterhin ein piezoelektrisches Vielschichtbauelement angegeben, das nach dem oben genannten Verfahren herstellbar ist, wobei die Störschichten nicht nur im Zwischenprodukt, sondern auch noch im Endprodukt erkennbar sind.

Die Störschicht wird vorzugsweise mittels eines der zuvor genannten Techniken erzeugt und mit einem Muster der zuvor genannten Art ausgebildet.

Die beschriebenen Gegenstände werden anhand der folgenden Figuren und Ausführungsbeispiele näher erläutert. Dabei zeigt:
- Figur 1: einen Längsschnitt eines schematisch dargestellten piezoelektrischen Vielschichtbauelements,
- Figur 2: einen Längsschnitt eines Bereichs eines schematisch dargestellten piezoelektrischen Vielschichtbauelements,
- Figuren 3a und 3b: verschiedene Rissbildungen in einem piezoelektrischen Vielschichtbauelement,
- Figur 4: einen Längsschnitt eines piezoelektrischen Vielschichtbauelements mit Störschichten,
- Figuren 5a und 5b: jeweils einen Längsschnitt eines piezoelektrischen Vielschichtbauelements mit einem Bereich verringerter Stabilität aufgrund eines Störmaterials,
- Figuren 6a bis 6d: unterschiedliche Formen einer Störschicht,
- Figuren 7a bis 7d: Aufsichten auf Störschichten mit unterschiedlichen geometrischen Mustern.

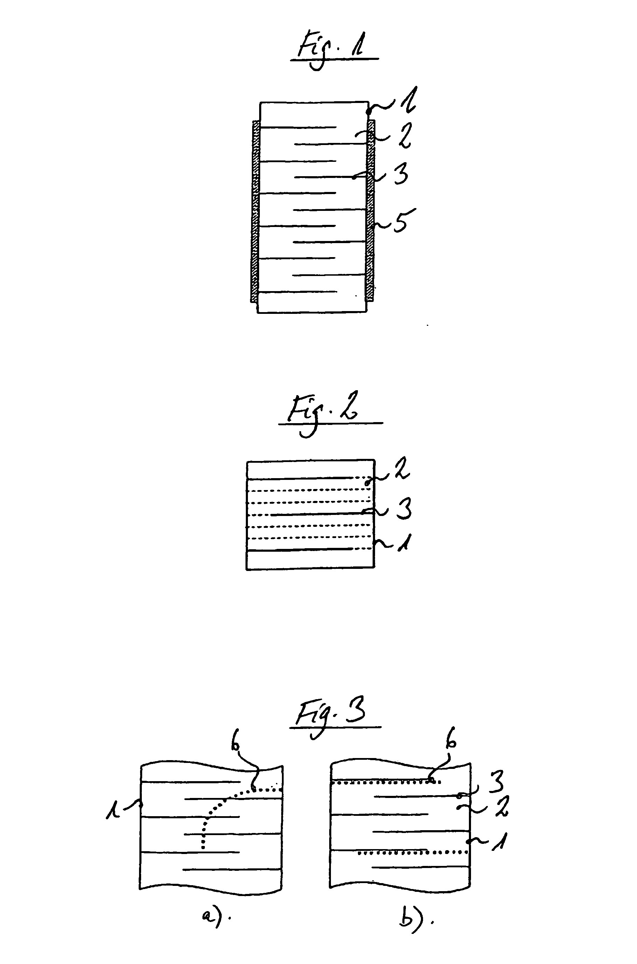

Figur 1 zeigt den Querschnitt eines schematisch dargestellten Piezoaktors, der einen Stapel 1 von piezokeramischen Schichten 2 und dazwischen liegenden Elektrodenschichten 3 aufweist. An zwei Längsseiten des Stapels 1 sind Außenkontakte als externe Metallisierungen 5 aufgebracht, die die bis an diese Längsseiten herangeführten Enden der Elektrodenschichten 3 kontaktieren. Benachbarte Elektrodenschichten unterschiedlicher Polarität überlappen sich in orthogonaler Projektion (welche parallel zur Stapelachse des Piezoaktors verläuft). Im Überlappbereich, der als aktive Zone bezeichnet werden kann, führt ein elektrisches Feld zur Erzeugung einer Auslenkung beziehungsweise Dehnung einer zwischen diesen Elektrodenschichten vorhandenen piezokeramischen Schicht 2. Der Bereich, in denen sich gegenpolige, benachbarte Elektrodenschichten 3 nicht überlappen, wird als inaktive Zone bezeichnet. In diesem Bereich kommt so gut wie keine Auslenkung durch den piezoelektrischen Effekt zustande. Das Material in den Elektrodenschichten 3 ist so gewählt, dass sie beim Sinterprozess nicht übermäßig aufschmelzen beziehungsweise dass die Struktur der aufgedruckten Elektrodenschicht bei und nach dem Sintern im Wesentlichen unverändert bleibt.

Figur 2 zeigt einen Abschnitt eines Stapels 1 eines Piezoaktors, bei dem zwischen gegenpoligen, benachbarten Elektrodenschichten 3 mehrere piezokeramische Schichten 2 übereinander gestapelt sein können. Auch ein solcher Abschnitt dient als Basis einer Konstruktion für nachfolgend beschriebene Ausführungsformen eines Piezoaktors, denn zwischen den zusätzlichen piezokeramischen Schichten 2 können Störschichten aufgebracht werden, welche chemische Reaktionen initiieren, um einen mechanisch geschwächten zweiten Bereich des Stapels zu erzeugen.

Figur 3a zeigt, wie ein Riss 6 mehrere Elektrodenschichten 3, insbesondere gegenpolige Elektrodenschichten 3 eines Piezoaktors verbindet.

Die Erfinder haben festgestellt, dass die Zuverlässigkeit eines Piezoaktors entscheidend von der Beherrschung eventuell auftretender Risse abhängt. Bei thermischen Prozessen wie zum Beispiel beim Sintern (Temperaturen zwischen 800 und 1500° C), Metallisieren und Löten sowie bei der Polarisation des (gesinterten) Piezoaktors entstehen aufgrund der unterschiedlichen Dehnung in der aktiven (angesteuerten) und inaktiven (isolierenden) Zone mechanische Spannungen, die zu so genannten Entlastungsrissen und/oder Polungsrissen des Piezoaktors führen. Diese laufen in der inaktiven Zone entlang oder in einer Elektrodenschicht 3. Beim Übergang in den aktiven Bereich können diese Risse abknicken. Wenn diese Risse dabei mindestens zwei Elektrodenschichten überbrücken, können Kurzschlüsse entstehen, die zum Versagen des Piezoaktors führen können. Risse, die parallel zu den Innenelektroden verlaufen, stellen dagegen nahezu keine Gefahr für die Lebensdauer von Piezoaktoren dar.

Figur 3b zeigt einen unschädlichen Verlauf eines Risses 6 im Stapel 1 eines Piezoaktors. Der Riss verläuft im Wesentlichen parallel zu einer Elektrodenschicht 3 beziehungsweise zu einer piezokeramischen Schicht 2, so dass der Riss keine gegenpoligen Elektrodenschichten verbindet und damit auch keine Kurzschlüsse verursacht.

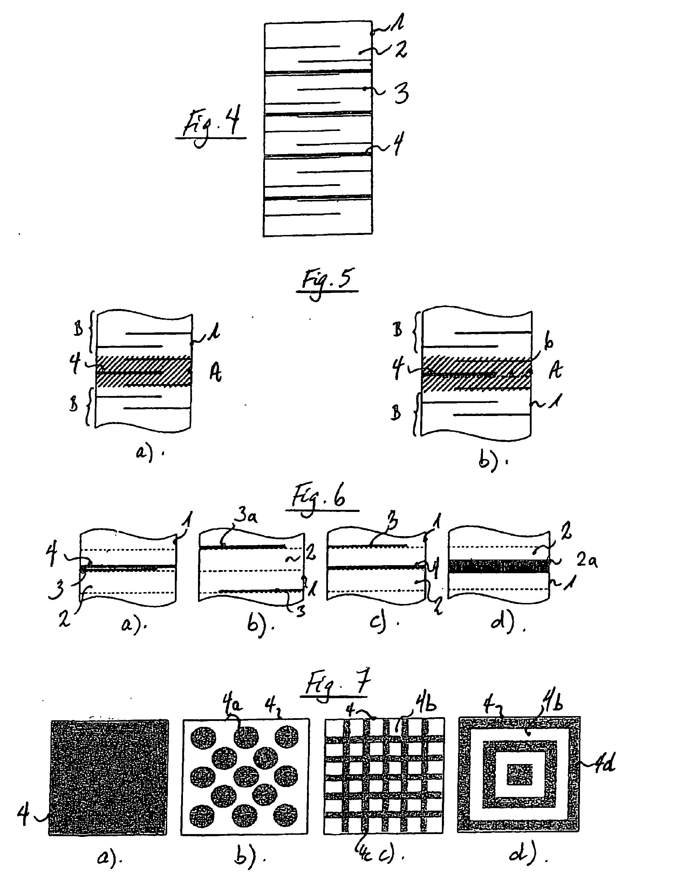

Figur 4 zeigt nun einen Piezoaktor als Zwischenprodukt, bei dem mehrere Störschichten 4 über die Höhe des Stapels 1 verteilt sind. Als Störmaterial können die Störschichten 4 Übergangsmetalle enthalten, wie beispielsweise Nickel, und jeweils auf einer Elektrodenschicht 3 aufgebracht sein. Die Störschichten 4 erstrecken sich hier über die gesamte Querschnittsfläche des Stapels 1.

Nickel als Störmaterial kann in verschiedenen Formen vorliegen, wie beispielsweise als metallisches Nickel, Nickeloxid, Nickel-Hydroxid oder Nickel-Salz. Das nickelhaltige Material kann mit einem piezokeramischen Pulver vermischt und auf eine bestehende Schicht des Stapels aufgebracht werden. Vorzugsweise wird hier Pulver der gleichen piezoelektrischen Keramik verwendet, wie sie für die piezokeramischen Schichten verwendet wird. Das nickelhaltige Material kann stattdessen auch mit einem metallischen Pulver vermischt und auf eine bestehende Schicht des Stapels aufgebracht werden. Vorzugsweise wird hier das gleiche metallische Material verwendet, wie es in den Elektrodenschichten des Stapels verwendet wird. Diese Materialien umfassen beispielsweise Kupfer, Silber, Palladium oder eine Legierung dieser Metalle. Im Fall, dass eine Elektrodenschicht als Störschicht fungiert (nicht erfindungsgemäß), kann das Störmaterial in die Paste für die Bedruckung der Elektrodenschicht beigemengt werden.

Die Figur 4 zeigt, wie jeweils eine Störschicht 4 auf eine Elektrodenschicht 3 aufgebracht ist. Die Störschicht kann an verschiedenen Stellen im Stapel angeordnet sein. Beispielsweise kann sie sich direkt auf einer Elektrodenschicht befinden, wie es in Figur 4 gezeigt wird. Die Störschicht kann aber auch zwischen zwei in Stapelrichtung benachbarten piezokeramischen Schichten aufgebracht sein, zwischen denen sich keine Elektrodenschicht 3 befindet.

Die vorzugsweise dünne, ein Dicke von bis zu 10 µm aufweisende Störschicht 4 aus nickelhaltigem Material kann während des Sinterns des Stapels 1 mit einer umliegenden Piezokeramik reagieren und verändert somit das Sinterverhalten der Piezokeramik.

Bezogen auf das an die Störschicht angrenzende Keramikmaterial in den Keramikschichten, die jeweils zwischen zwei benachbarten Innenelektroden angeordnet sind, beträgt im Falle der Verwendung von Nickel als Störmaterial der Nickelgehalt 0,05 bis 10 mol-%, vorzugsweise 0,5 bis 6 mol-% des piezokeramischen Materials.

Falls eine piezokeramische Schicht mit dem ersten Material dotiert ist, versteht sich die oben genannte Menge als zusätzliche Menge über dem vorhandenen Nickelgehalt in der Keramik.

Der Abstand zwischen jeweils zwei in Stapelrichtung benachbarten Störschichten liegt vorzugsweise zwischen 0,5 und 5 mm, vorzugsweise zwischen 0,6 und 2,5 mm.

Figur 5a zeigt ein nicht erfindungsgemäßes Ausführungsbeispiel. Figur 5a zeigt einen schraffierten zweiten Bereich A, der aufgrund des Störmaterials mechanisch gegenüber einem ersten Bereich B geschwächt ist. Während des Sinterns ist das Störmaterial aus der Störschicht 4 in die angrenzenden piezokeramischen Schichten diffundiert und hat zu einer Störung im Sinterverhalten geführt. Da der erste Bereich B in größerer Entfernung von der Störschicht 4 liegt, ist weniger Störmaterial in diesen Bereich diffundiert. Der erste Bereich B umgibt den zweiten Bereich A in Stapelrichtung.

Figur 5b zeigt ein nicht erfindungsgemäßes Ausführungsbeispiel. Figur 5b zeigt, wie sich durch diesen ersten Bereich A bei einer mechanischen Belastung des Stapels ein kontrollierter Riss 6 ausbilden kann. Der Riss verläuft innerhalb des ersten Bereichs A in der Nähe der im Zwischenprodukt aufgetragenen Störschicht 4. Dies ist darauf zurückzuführen, dass die piezokeramische Schicht umso mehr geschwächt ist, je näher sie an der Störschicht 4 liegt. Die mechanische Stabilität der piezokeramischen Schichten kann sich kontinuierlich in Richtung wachsender Entfernung von der Störschicht 4 verringern. Der Übergang zwischen dem zweiten Bereich A und dem ersten Bereich B kann somit auch fließend verlaufen.

Die Figuren 6a bis 6d zeigen verschiedene Anordnungsmöglichkeiten von Störmaterial in einem Zwischenprodukt, wobei Figur 6b ein nicht erfindungsgemäßes Ausführungsbeispiel zeigt.

Figur 6a zeigt eine Störschicht 4, die auf eine Elektrodenschicht 3 aufgebracht ist. Im Unterschied zur Elektrodenschicht 3 erstreckt sich die Störschicht 4 über den gesamten Querschnitt des Stapels.

Figur 6b (nicht erfindungsgemäß) zeigt, eine Elektrodenschicht 3a, in die Störmaterial eingebracht ist. Das Störmaterial ist hier nicht in alle Elektrodenschichten 3 eingebracht.

Figur 6c zeigt, wie eine Störschicht 4 über den gesamten Querschnitt des Stapels 1 verläuft und auf einer piezokeramischen Schicht 2 aufgebracht ist.

Figur 6d zeigt eine mit Störmaterial dotierte piezokeramische Schicht 2a. Während des Sinterns verändert das Störmaterial das Sinterverhalten dieser piezokeramischen Schicht 2a und kann zudem auch in weitere, angrenzende piezokeramische Schichten 2 diffundieren und deren Sinterverhalten stören.

Figur 7a zeigt ein nicht erfindungsgemäßes Ausführungsbeispiel. Figur 7a zeigt eine Aufsicht auf eine Störschicht 4, die die gesamte Querschnittsfläche des Stapels abdeckt. Beispielsweise bedeckt die Störschicht 4 eine piezokeramische Schicht 2 oder eine Elektrodenschicht 3.

Figur 7b zeigt eine Aufsicht auf eine Störschicht 4, die als Anordnung von Inseln 4a, die nur einen Teil der Oberfläche einer Schicht 2, 3 des Stapels abdecken, ausgeführt ist. Die Inseln 4a sind hier kreisförmig, jedoch können sie jeweils einen beliebigen anderen Umriss aufweisen, beispielsweise einen polygonalen Umriss. Die Inseln 4a sind in einem regelmäßigen Muster auf einer Schicht 2, 3 des Stapels 1 aufgebracht, so dass sie jeweils die gleichen Abstände zueinander aufweisen. Vorzugsweise sind die Inseln 4a gleichmäßig über die Querschnittsfläche des Stapels 1 verteilt.

Figur 7c zeigt eine Störschicht 4, die als Netzstruktur 4c auf einer Schicht 2, 3 des Stapels aufgebracht ist. Somit ist das Störmaterial in einer zusammenhängenden Struktur, welche quadratische Aussparungen 4b einschließt, auf der Schicht 2, 3 angeordnet.

Figur 7d zeigt eine Störschicht 4, die als eine Anordnung von konzentrischen, rahmenförmigen Bereichen 4d des Störmaterials auf einer Schicht 2, 3 des Stapels aufgebracht ist. Diese Bereiche des Störmaterials können dabei kreisförmige oder quadratische Umrisse aufweisen. Sie können als rahmenförmige Inseln, die ein gemeinsames Zentrum aufweisen, verstanden werden.

Die in den obigen Figuren gezeigten Störschichten sind vorzugsweise nicht nur im Zwischenprodukt, sondern auch noch im Endprodukt erkennbar.

Im Folgenden werden bevorzugte Materialzusammensetzungen sowie Konstruktionen eines piezoelektrischen Vielschichtbauelements mit Störschichten angegeben. Dabei sind auch beliebige Kombinationen der in den erfindungsgemäßen Ausführungsformen genannten Materialien und der Anordnung des Störmaterials denkbar.

Die piezokeramischen Schichten enthalten beispielsweise eine Keramik mit einer Zusammensetzung gemäß den.folgenden Formeln:

(PbₓNd_{y}) ((Zr_{1-z}Ti_{z})₁₋ₐNiₐ)O₃,

wobei
0,90 ≤ x ≤ 1,10;
0,0001 ≤ y ≤ 0,06;
0,35 ≤ z ≤ 0,60;
0 ≤ a ≤ 0,10.

Gemäß einer ersten Ausführungsform umfasst das Störmaterial eine Paste enthaltend Nickeloxid mit einem organischen Binder. Die Störschicht wird mittels Siebdruck auf eine Elektrodenschicht aufgebracht. Die Konzentration des auf die Elektrodenschicht aufgebrachten Nickels liegt zwischen 0,5 und 6 mol % bezogen auf die Piezokeramik angrenzender beziehungsweise benachbarter piezokeramischer Schichten. Der Abstand zwischen zwei in Stapelrichtung benachbarten Störschichten liegt zwischen 0,6 und 2,5 mm. Die Störschicht wird über eine Elektrodenschicht aufgebracht und erstreckt sich über die gesamte Querschnittsfläche des Stapels. Die Elektrodenschichten enthalten als Metall vorzugsweise ausschließlich Kupfer.

Gemäß einer weiteren Ausführungsform umfasst der nickelhaltige Stoff eine Pulvermischung einer Legierung von Nickel und Kupfer mit einem organischen Binder. Das Störmaterial ist in diesem Fall einer Elektrodenschicht beigemengt (nicht erfindungsgemäß). Die Elektrodenschicht wird mittels Siebdruck erzeugt. Die Konzentration des aufgebrachten Nickels liegt zwischen 0,5 und 6 mol % bezogen auf die Piezokeramik angrenzender piezokeramischer Schichten. Der Abstand zwischen zwei in Stapelrichtung benachbarten Störschichten liegt zwischen 0,6 und 2,5 mm. Die Form der nicht erfindungsgemäßen nickelhaltigen Elektrodenschicht entspricht der Form weiterer Elektrodenschichten, die als Metall ausschließlich Kupfer enthalten.

Gemäß einer weiteren Ausführungsform umfasst der nickelhaltige Stoff eine Paste enthaltend Nickeloxid und Kupfer mit einem organischen Binder. Das Störmaterial ist auch hier einer Elektrodenschicht beigemengt (nicht erfindungsgemäß), die mittels Siebdruck aufgebracht wird. Die Konzentration des aufgebrachten Nickels liegt zwischen 0,5 und 6 mol % bezogen auf die Piezokeramik angrenzender piezokeramischer Schichten. Der Abstand zwischen zwei in Stapelrichtung benachbarten Störschichten liegt zwischen 0,6 und 2,5 mm. Die Form der nickelhaltigen Elektrodenschicht entspricht der Form weiterer Elektrodenschichten, die als Metall ausschließlich Kupfer enthalten.

### Bezugszeichenliste

- 1: Stapel aus piezokeramischen Schichten und Elektrodenschichten
- 2: piezokeramische Schicht
- 2a: piezokeramische Schicht mit Störmaterial
- 3: Elektrodenschicht
- 3a: Elektrodenschicht mit Störmaterial
- 4: Störschicht
- 4a: Inseln
- 4b: Aussparungen
- 4c: Netzstruktur
- 4d: rahmenförmige Bereiche
- 5: Außenkontakt
- 6: Riss

- A: zweiter Bereich
- B: erster Bereich

## Patentansprüche

1. Piezoelektrisches Vielschichtbauelement als Zwischenprodukt, aufweisend:
- einen Stapel (1) von übereinander angeordneten grünen piezokeramischen Schichten (2) und dazwischen liegenden Elektrodenschichten (3),
- mit einem ersten Bereich (B) und einem zweiten Bereich (A) des Stapels (1),
- wobei im Stapel wenigstens eine zusätzliche Störschicht (4) eingebracht ist, die ein Störmaterial enthält,
- wobei sich die Störschicht (4) über die gesamte Querschnittsfläche des Stapels erstreckt,
- wobei das Störmaterial dazu geeignet ist, das Sinterverhalten des Materials im zweiten Bereich (A) so zu verändern, dass eine mechanische Schwächung des zweiten Bereichs (A) gegenüber dem ersten Bereich (B) hervorgerufen wird,
- wobei das Störmaterial ein Übergangsmetall und/oder eine chemische Verbindung umfasst, die gewählt ist aus einem: Oxid, Hydroxid, Salz und
- wobei der zweite Bereich piezokeramisches Material aufweist
**dadurch gekennzeichnet, dass**
die Störschicht (4) strukturiert ist und ein regelmäßiges geometrisches Muster aufweist, wobei sie eine Schicht (2, 3) des Stapels (1) unvollständig abdeckt.

2. Vielschichtbauelement nach Anspruch 1,
bei dem die Störschicht (4) auf eine Elektrodenschicht (3) aufgebracht ist.

3. Vielschichtbauelement nach Anspruch 1,
bei dem die Störschicht (4) auf eine piezokeramische Schicht (2) aufgebracht ist.

4. Vielschichtbauelement nach Anspruch 1,
bei dem eine piezokeramische Schicht (2) mit dem Störmaterial dotiert ist.

5. Vielschichtbauelement nach einem der Ansprüche 1 bis 4, bei dem der zweite Bereich (B) Teile einer piezokeramischen Schicht (2) umfasst, die an das Störmaterial angrenzen.

6. Verfahren zur Herstellung eines piezoelektrischen Vielschichtbauelements,
- wobei ein als Zwischenprodukt hergestelltes piezoelektrisches Vielschichtbauelement nach einem der vorhergehenden Ansprüche gesintert wird und
- wobei während des Sinterns das Störmaterial das Sinterverhalten des Materials im zweiten Bereich (A) so verändert, dass eine mechanische Schwächung des zweiten Bereichs (A) gegenüber dem ersten Bereich (B) eintritt.

7. Piezoelektrisches Vielschichtbauelement herstellbar nach dem Verfahren aus Anspruch 6.

8. Vielschichtbauelement nach Anspruch 7,
- bei dem im zweiten Bereich (A) und im ersten Bereich (B) piezokeramisches Material vorliegt, und
- bei dem das Gefüge des piezokeramischen Materials im zweiten Bereich (A) gegenüber dem Gefüge des piezokeramischen Materials im ersten Bereich (B) verändert ist.

9. Vielschichtbauelement nach einem der Ansprüche 7 oder 8, bei dem das piezokeramischen Materials im zweiten Bereich (A) eine höhere Porosität aufweist, als das piezokeramische Material im ersten Bereich (B).

## Claims

1. Piezoelectric multilayer component as an intermediate product, having:
- a stack (1) of green piezoceramic layers (2), which are arranged one on top of the other, and electrode layers (3) which are located between them,
- having a first area (B) and a second area (A) of the stack (1),
- wherein at least one additional disturbance layer (4), which contains a disturbance material, is incorporated in the stack,
- wherein the disturbance layer (4) extends over the entire cross-sectional area of the stack,
- wherein the disturbance material is suitable for changing the sintering behavior of the material in the second area (A) so as to make the second area (A) mechanically weaker than the first area (B),
- wherein the disturbance material comprises a transition metal and/or a chemical compound which is chosen from an: oxide, hydroxide, salt, and
- wherein the second area comprises piezoceramic material,
**characterized in that**
the disturbance layer (4) is structured and has a regular geometric pattern, wherein the disturbance layer (4) incompletely covers a layer (2, 3) of the stack (1).

2. Multilayer component according to Claim 1,
in which the disturbance layer (4) is applied to an electrode layer (3).

3. Multilayer component according to Claim 1,
in which the disturbance layer (4) is applied to a piezoceramic layer (2).

4. Multilayer component according to Claim 1,
in which a piezoceramic layer (2) is doped with the disturbance material.

5. Multilayer component according to one of Claims 1 to 4,
in which the second area (B) comprises parts of a piezoceramic layer (2) which is adjacent to the disturbance material.

6. Method for producing a piezoelectric multilayer component,
- wherein a piezoelectric multilayer component according to one of the preceding claims, and which is produced as an intermediate product, is sintered, and
- wherein, during the sintering, the disturbance material changes the sintering behavior of the material in the second area (A) so as to make the second area (A) mechanically weaker than the first area (B).

7. Piezoelectric multilayer component which can be produced using the method from Claim 6.

8. Multilayer component according to Claim 7,
in which there is piezoceramic material in the second area (A) and in the first area (B), and
- in which the structure of the piezoceramic material in the second area (A) is changed in comparison to the structure of the piezoceramic material in the first area (B).

9. Multilayer component according to one of Claims 7 or 8,
in which the piezoceramic material in the second area (A) has a higher porosity than the piezoceramic material in the first area (B).

## Revendications

1. Élément piézoélectrique multicouche servant de produit intermédiaire, comportant :
- une pile (1) de couches piézocéramiques (2) vertes disposées les unes au-dessus des autres et comportant entre des couches d'électrode (3) posées à plat ;
- avec une première zone (B) et une deuxième zone (A) de la pile (1) ;
- au moins une couche de brouillage (4) supplémentaire étant amenée dans la pile, ladite couche contenant un matériau de brouillage ;
- la couche de brouillage (4) s'étendant sur la totalité de la surface de section transversale de la pile ;
- le matériau de brouillage étant adapté pour modifier de telle sorte le comportement de frittage du matériau contenu dans la deuxième zone (A) qu'une fragilisation mécanique de la deuxième zone (A) est induite par rapport à la première zone (B) ;
- le matériau de brouillage comprenant un métal de transition et/ou une liaison chimique sélectionné parmi un oxyde, un hydroxyde, un sel ; et
- la deuxième zone comportant un matériau piézocéramique ;
**caractérisé en ce que** :
la couche de brouillage (4) est structurée et présente un modèle géométrique régulier, ladite couche ne recouvrant pas entièrement la couche (2, 3) de la pile (1).

2. Élément multicouche selon la revendication 1, dans lequel la couche de brouillage (4) est appliquée sur une couche d'électrode (3).

3. Élément multicouche selon la revendication 1, dans lequel la couche de brouillage (4) est appliquée sur une couche piézocéramique (2).

4. Élément multicouche selon la revendication 1, dans lequel une couche piézocéramique (2) est dotée d'un matériau de brouillage.

5. Élément multicouche selon l'une quelconque des revendications 1 à 4, dans lequel la deuxième zone (B) comprend des parties d'une couche piézocéramique (2) connexe au matériau de brouillage.

6. Procédé de fabrication d'un élément piézoélectrique multicouche,
- un élément piézoélectrique multicouche fabriqué comme un produit intermédiaire selon l'une quelconque des revendications précédentes étant fritté ; et
- pendant le frittage du matériau de brouillage, le comportement de frittage du matériau dans la deuxième zone (A) étant modifié de telle sorte qu'une fragilisation mécanique de la deuxième zone (A) se produit par rapport à la première zone (B).

7. Élément piézoélectrique multicouche pouvant être fabriqué selon le procédé de la revendication 6.

8. Élément multicouche selon la revendication 7,
- dans lequel on observe la présence de matériau piézocéramique dans la deuxième zone (A) et dans la première zone (B) ; et
- dans lequel la texture du matériau piézocéramique dans la deuxième zone (A) est modifiée par rapport à la structure du matériau piézocéramique dans la première zone (B).

9. Élément multicouche selon l'une quelconque des revendications 7 ou 8, dans lequel le matériau piézocéramique comporte une porosité supérieure dans la deuxième zone (A) que le matériau piézocéramique dans la première zone (B).
